# EUROPEAN PATENT APPLICATION

(11) **EP 1 467 570 A1**
(43) Date of publication of application: **13.10.2004**
(21) Application number: 03290875.8
(22) Date of filing: 08.04.2003
(51) Int. Cl.: H04N 7/50, H04N 7/64

(54) **Method and apparatus for creating a robust video bit stream**

(71) Applicant: ALCATEL, 75008 Paris (FR)
(72) Inventor: Nguyen, Hang, 92110 Clichy-la-Garenne (FR); Brouet, Jérome, 75014 Paris (FR)
(74) Representative: Wörz, Volker

(57) **Abstract**

The invention refers to a method and apparatus (10) for creating a compressed video bit stream (3) from video information (1) comprising the steps of:
a) receiving the video information (1) to be compressed;
b) receiving code words from a codebook comprising a plurality of codes for encoding the video information (1); and
c) encoding the video information (1) and creating the video bit stream (3) using said code words received from the codebook.

In order to increase robustness of the video bit stream (3) against bit-errors, in particular in order to reduce error propagation, it is suggested that the code words used for encoding the video information (1) have a fixed length (k).

## Description

The present invention refers to a method for creating a compressed video bit stream from video information for transmission over a non-reliable data-link, comprising the steps of:
a) receiving the video information to be compressed;
b) receiving code words from a codebook comprising a plurality of codes for encoding the video information; and
c) encoding the video information and creating the video bit stream using said code words received from the codebook.

The invention further refers to a method for transmitting video information across a non-reliable data-link, wherein the video information is compressed into a video bit stream and the video bit stream is transmitted across the data-link. The non-reliable data-link could be, for example, a data-link across a wireless network.

Moreover, the invention refers to a method for creating decompressed video information from a video bit stream transmitted over a non-reliable data-link comprising the steps of:
a) receiving the video bit stream to be decompressed;
b) receiving code words from a codebook comprising a plurality of codes for encoding the video information; and
c) decoding the video bit stream and creating the video information using said code words received from the codebook.

Furthermore, the invention refers to a method for receiving video information across a transmission media, wherein a video bit stream comprising compressed video information is transmitted across the transmission media and the video bit stream is decompressed in order to create the video information.

Further, the present invention refers to an apparatus for creating a compressed video bit stream from video information, the apparatus comprising:
a) means for receiving the video information to be compressed;
b) a codebook comprising a plurality of codes for encoding the video information;
c) means for receiving code words from the codebook; and
d) a video encoder for encoding the video information and creating the video bit stream using said code words received from the codebook.

Finally, the present invention refers to an apparatus for creating decompressed video information from a video bit stream comprising:
a)means for receiving the video bit stream to be decompressed;
b)means for receiving code words from a codebook comprising a plurality of codes for encoding the video information; and
c)means for encoding the video bit stream and creating the video information using said code words received from the codebook.

The present invention relates to multimedia transmission over non-reliable data-links like wireless networks, in particular over radio networks, for example to the transmission of compressed video information to mobile communication terminals, such as mobile phones. For non real-time applications a delay of the transmission is not critical. For these applications the channel used for transmission can be made extremely reliable by the use of suitable retransmission protocols, for example ARQ (Automatic Repeat request).

However, with real-time applications like multimedia transmission across a wireless network the retransmission protocols like ARQ cannot be used anymore, especially when the repetition period is large compared to delay constraints. For these applications transmission is not reliable, which results in errors in the transmitted compressed video sequences. Therefore, according to the prior art reliable media is commonly used for image and video storage and transmission under real-time requirements.

In commonly used video compression standards, video information is compressed spatially and temporarily. Video information in the sense of the present invention comprises static information (images and pictures) as well as dynamic information (videos and films). For a temporal compression only the first image or one image periodically of the video sequence is entirely encoded. For the following images, only the differences between the images and the first or periodical image are encoded. For a spatial compression the video information is compressed twice:
- Firstly, the video information is compressed by a transform compression technology, such as DCT (Discrete Cosine Transform)- or wavelet-based image coding.
- Secondly, the video information is compressed by an entropy compression technology, such as a coding based on a Huffman code, an arithmetic code, a RVLC (Reversible Variable Length Coding) or a U-VLC (Variable Length Coding).

All of these entropy compression technologies are VLC-based. For instance, the H.263 compression technology uses the Huffman code, the H.263+ compression technology uses RVLC-based codes and the H.26L compression technology uses U-VLC-based codes.

The compressed video bit stream is hierarchically organized into several layers:
- a picture layer,
- a GOB (Group Of Blocks) layer,
- a MB (Macro Blocks) layer and
- the blocks themselves.

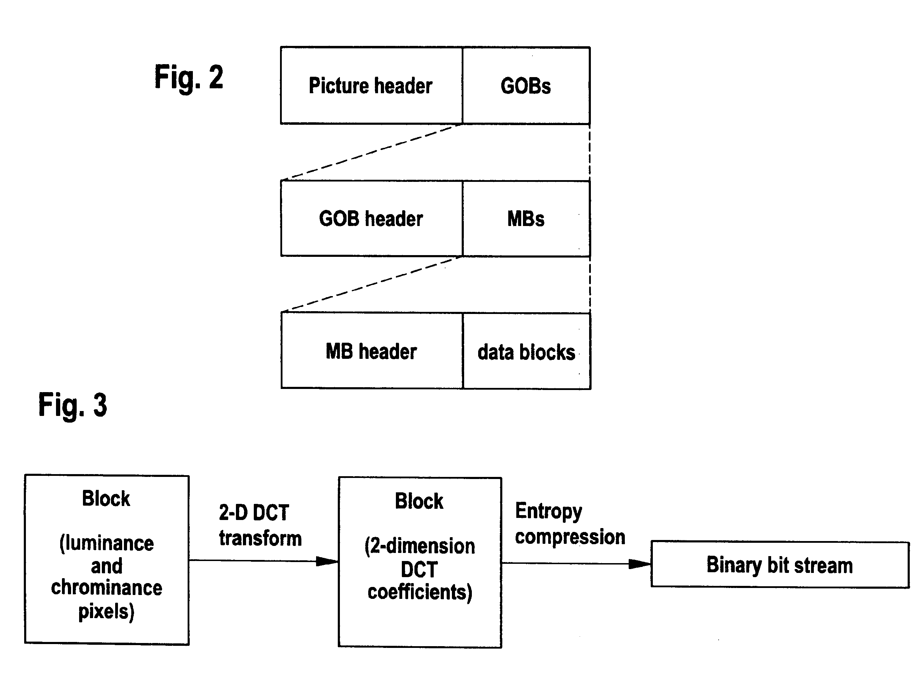

Each layer comprises a layer header and some data fields (of the following layer). The picture layer comprises a picture header and GOBs, the GOB layer comprises a GOB header and MBs and the MB layer comprises a MB header and the data blocks. The hierarchical organization of the compressed video bit stream is shown in figure 2.

The spatial and temporal compression described above is applied to the data blocks. A flowchart of the spatial compression, comprising the transform compression and the entropy compression, is shown in figure 3. The data blocks comprising luminance and chrominance pixels are processed by means of a 2-dimensional DCT. The data blocks comprising the 2-dimensional DCT coefficients are processed by means of the entropy compression in order to obtain the binary bit stream. The entropy compression is made with a triplet (run, level, last) or (run, level, end-of-block) taken from a codebook comprising a plurality of codes for encoding the video information. Table 1 underlines the fact that only a limited number of code words from the dictionary are used in typical video sequences. In Table 1 VS stands for Video Sequence.

**Table 1:**

| Example for content of a VLC-codebook | | | | | | | |
|---|---|---|---|---|---|---|---|
| **Triplet** **(run, level, last number)** | **Length of code** **words with VLC** | **VS1** **[%]** | **VS2** **[%]** | **VS3** **[%]** | **VS4** **[%]** | **Mean** **[%]** | **Theoretical probabilities** **[%]** |
| 1 | 2 | 16 | 20 | 18 | 20 | 19 | 25 |
| 2 | 3 | 7 | 8 | 7 | 8 | 8 | 13 |
| 3 | 4 | 5 | 8 | 6 | 10 | 7 | 6 |
| 4 | 4 | 5 | 5 | 4 | 5 | 5 | 6 |
| 5 | 4 | 10 | 10 | 12 | 4 | 9 | 6 |
| 6 | 5 | 3 | 3 | 2 | 3 | 3 | 3 |
| 7 | 5 | 2 | 2 | 2 | 2 | 2 | 3 |
| 8 | 5 | 2 | 2 | 1 | 2 | 2 | 3 |
| 9 | 6 | 2 | 4 | 3 | 5 | 4 | 1,5 |
| 10 | 6 | 2 | 3 | 2 | 3 | 2 | 1,5 |
| 11 | 6 | 1 | 1 | 1 | 2 | 1 | 1,5 |
| 12 | 6 | 1 | 1 | 1 | 1 | 1 | 1,5 |
| 13 | 6 | 1 | 1 | 1 | 1 | 1 | 1,5 |
| 14 | 6 | 1 | 0 | 1 | 1 | 1 | 1,5 |
| 15 | 6 | 5 | 5 | 5 | 2 | 4 | 1,5 |
| 16 | 6 | 3 | 3 | 4 | 1 | 3 | 1,5 |
| 17 | 6 | 3 | 2 | 2 | 1 | 2 | 1,5 |
| 18 | 6 | 3 | 2 | 3 | 1 | 2 | 1,5 |
| 19 | 7 | 1 | 2 | 1 | 3 | 2 | 0,7 |
| 20 | 7 | 0 | 0 | 0 | 0 | 0 | 0,7 |
| 21 | 7 | 0 | 0 | 0 | 0 | 0 | 0,7 |
| 22 | 7 | 0 | 0 | 0 | 0 | 0 | 0,7 |
| 23 | 7 | 3 | 2 | 3 | 1 | 0 | 0,7 |
| 24 | 7 | 2 | 1 | 2 | 1 | 0 | 0,7 |
| 25 | 7 | 2 | 1 | 2 | 1 | 0 | 0,7 |
| 26 | 7 | 2 | 1 | 1 | 1 | 0 | 0,7 |
| 27 | 8 | 0 | 1 | 1 | 2 | 0 | 0,4 |
| 28 | 8 | 1 | 1 | 1 | 1 | 0 | 0,4 |
| 29 | 8 | 1 | 1 | 1 | 1 | 0 | 0,4 |
| 30 | 8 | 0 | 0 | 0 | 0 | 0 | 0,4 |
| 31 | 8 | 0 | 0 | 0 | 0 | 0 | 0,4 |
| 32 | 8 | 1 | 1 | 1 | 1 | 0 | 0,4 |
| 33 | 8 | 1 | 1 | 1 | 0 | 0 | 0,4 |
| 34 | 8 | 1 | 0 | 1 | 1 | 0 | 0,4 |
| 35 | 8 | 1 | 1 | 1 | 0 | 0 | 0,4 |
| 36 | 8 | 1 | 0 | 1 | 1 | 0 | 0,4 |
| 37 | 8 | 1 | 0 | 1 | 0 | 0 | 0,4 |
| 38 | 8 | 0 | 0 | 0 | 0 | 0 | 0,4 |
| 39 | 8 | 1 | 0 | 0 | 0 | 0 | 0,4 |
| 40 | 9 | 0 | 0 | 0 | 1 | 0 | 0,2 |
| 41 | 9 | 0 | 0 | 0 | 1 | 0 | 0,2 |
| 42 | 9 | 0 | 1 | 0 | 1 | 0 | 0,2 |
| 43 | 9 | 0 | 0 | 0 | 0 | 0 | 0 |
| 44 | 9 | 0 | 0 | 0 | 0 | 0 | 0 |
| 45 | 9 | 0 | 0 | 0 | 0 | 0 | 0 |
| 46 | 9 | 0 | 0 | 0 | 0 | 0 | 0 |
| 47 | 9 | 0 | 0 | 0 | 0 | 0 | 0 |
| 48 | 9 | 0 | 0 | 0 | 0 | 0 | 0 |
| 49 | 9 | 0 | 0 | 0 | 0 | 0 | 0 |
| 50 | 9 | 0 | 0 | 0 | 0 | 0 | 0 |
| 51 | 9 | 0 | 0 | 0 | 0 | 0 | 0 |
| 52 | 9 | 1 | 1 | 1 | 1 | 0 | 0 |
| 53 | 9 | 1 | 0 | 0 | 0 | 0 | 0 |
| 54 | 9 | 1 | 0 | 0 | 0 | 0 | 0 |
| 55 | 9 | 0 | 0 | 0 | 0 | 0 | 0 |
| 56 | 9 | 0 | 0 | 0 | 0 | 0 | 0 |
| 57 | 9 | 0 | 0 | 0 | 0 | 0 | 0 |
| 58 | 9 | 0 | 0 | 0 | 0 | 0 | 0 |
| 59 | 9 | 0 | 0 | 0 | 0 | 0 | 0 |
| 60 | 9 | 0 | 0 | 0 | 0 | 0 | 0 |
| 61 | 10 | 0 | 0 | 0 | 1 | 0 | 0,1 |
| 62 | 10 | 0 | 0 | 0 | 0 | 0 | 0,1 |
| 63 | 10 | 0 | 0 | 0 | 1 | 0 | 0,1 |
| 64 | 10 | 0 | 0 | 0 | 0 | 0 | 0,1 |
| 65 | 10 | 0 | 0 | 0 | 0 | 0 | 0 |
| 66 | 10 | 0 | 0 | 0 | 0 | 0 | 0 |
| 67 | 10 | 0 | 0 | 0 | 0 | 0 | 0 |
| 68 | 10 | 0 | 0 | 0 | 0 | 0 | 0 |
| 69 | 10 | 0 | 0 | 0 | 0 | 0 | 0 |
| 70 | 10 | 0 | 0 | 0 | 0 | 0 | 0 |
| 71 | 10 | 0 | 0 | 0 | 0 | 0 | 0 |
| 72 | 10 | 0 | 0 | 0 | 0 | 0 | 0 |
| 73 | 10 | 0 | 0 | 0 | 0 | 0 | 0 |
| 74 | 10 | 0 | 0 | 0 | 0 | 0 | 0 |
| 75 | 11 | 0 | 0 | 0 | 0 | 0 | 0 |
| 76 | 11 | 0 | 0 | 0 | 0 | 0 | 0 |
| 77 | 11 | 0 | 0 | 0 | 0 | 0 | 0 |
| 78 | 11 | 0 | 0 | 0 | 0 | 0 | 0 |
| 79 | 11 | 0 | 0 | 0 | 0 | 0 | 0 |
| 80 | 11 | 0 | 0 | 0 | 0 | 0 | 0 |
| 81 | 11 | 0 | 0 | 0 | 0 | 0 | 0 |
| 82 | 11 | 0 | 0 | 0 | 0 | 0 | 0 |
| 83 | 11 | 0 | 0 | 0 | 0 | 0 | 0 |
| 84 | 11 | 0 | 0 | 0 | 0 | 0 | 0 |
| 85 | 11 | 0 | 0 | 0 | 0 | 0 | 0 |
| 86 | 11 | 0 | 0 | 0 | 0 | 0 | 0 |
| 87 | 12 | 0 | 0 | 0 | 0 | 0 | 0 |
| 88 | 12 | 0 | 0 | 0 | 0 | 0 | 0 |
| 89 | 12 | 0 | 0 | 0 | 0 | 0 | 0 |
| 90 | 12 | 0 | 0 | 0 | 0 | 0 | 0 |
| 91 | 12 | 0 | 0 | 0 | 0 | 0 | 0 |
| 92 | 12 | 0 | 0 | 0 | 0 | 0 | 0 |
| 93 | 12 | 0 | 0 | 0 | 0 | 0 | 0 |
| 94 | 12 | 0 | 0 | 0 | 0 | 0 | 0 |
| 95 | 12 | 0 | 0 | 0 | 0 | 0 | 0 |
| 96 | 12 | 0 | 0 | 0 | 0 | 0 | 0 |
| 97 | 12 | 0 | 0 | 0 | 0 | 0 | 0 |
| 98 | 12 | 0 | 0 | 0 | 0 | 0 | 0 |
| 99 | 12 | 0 | 0 | 0 | 0 | 0 | 0 |
| 100 | 12 | 0 | 0 | 0 | 0 | 0 | 0 |
| 101 | 12 | 0 | 0 | 0 | 0 | 0 | 0 |
| 102 | 12 | 0 | 0 | 0 | 0 | 0 | 0 |

Variable length codes (VLC) are very sensitive to errors. These code words are characterized by a precondition for the prefix that no code word can be the prefix of another code word. A decoder used for decoding the VLC-encoded video information, uses this requirement to separate the code words in order to instantaneously decode the received video bit stream. If an error occurs on one of the VLC-bits of the video bit stream, in contrast to the above-mentioned requirement, the code word can become the prefix of another code word. In this case, that part of the video bit stream would be decoded as part of another code word. This would result in a loss of synchronization because the bit-error would be propagated to subsequent code words which would be misunderstood, too. For example:
If the transmitted video bit stream sequence is 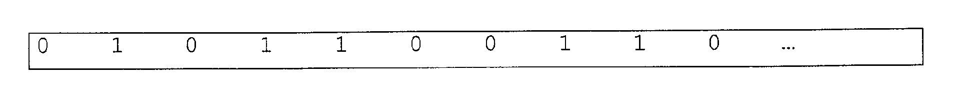 the code words' sequence of the bit stream is: 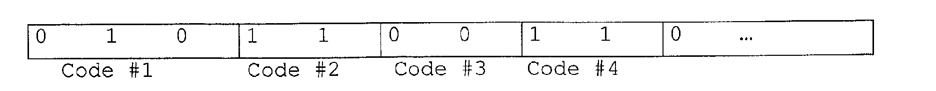
If the received video bit stream sequence had an error on the second bit of the sequence transmitting 0 instead of 1, the sequence is: 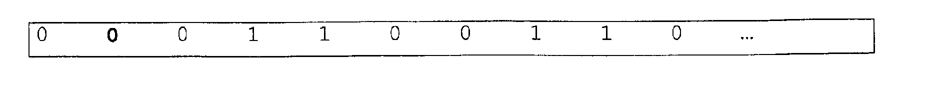
Here, only one bit of the video bit stream is erroneous. But during decoding of the bit stream a totally different code word sequence is determined since according to the codebook "00" is a valid code word:

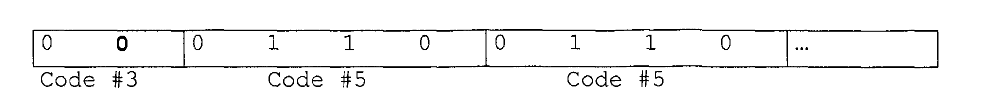

Spatially, the errors will propagate until the decoder realizes that an error has occurred and/or the following synchronization sequence is found: The decoder would realize that an error has occurred if it cannot find any code word matching the VLC sequence. Looking at the H.263-standard, the whole group of blocks (GOB) or picture (or even several of them) will be lost. How much of the video information would be lost depends on the compression options (insertion of synchronization code between GOBs or pictures) and on the instant that the decoder realizes that an error has occurred and on the instant that the subsequent valid synchronization code is found. Temporally, the bit-errors propagate until the next INTRA-coded frame or the next INTRA-coded block is received. INTRA-coded frames and blocks are coded with no reference to other frames or blocks and therefore can be reconstructed without any reference to other frames or blocks.

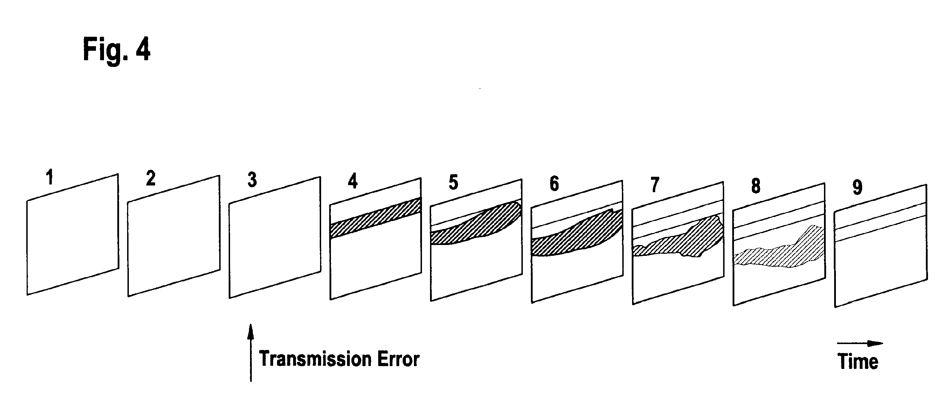

Simulations showed that VLC-synchronization loss is one of the most important problems when transmitting video information over non-reliable transmission media, for example over a channel of a wireless communication network like EDGE (Enhanced Data Rate for GSM Evolution). Figure 4 by way of example shows an illustration of spatial temporal error propagation for the H.263 coding standard.

It is further known from the prior art to transmit a H.263 or a MPEG-4 video bit stream directly to a mobile telecommunication terminal across a mobile network. For this purpose a RTP (Real-time Transmission Protocol)-layer can be added. However that layer does not deal with the VLC-synchronization loss problem described above. The only error protection of the video bit stream available are the error protection mechanisms available on the transmission medium, that is on the wireless network.

For instance, when looking at EGPRS (Enhanced GPRS) wireless channels, the protection against transmission errors depends on the modulation and coding schemes (MCS; Modulation Coding Schemes) currently used. It is well known that radio links used for transmitting a VLC-encoded video bit stream cannot offer a low BER (Bit-Error Rate) and a high transfer rate at the same time. However, on the one hand a low BER is required for a transmission of video information with an acceptable quality. On the other hand a high transfer rate is required in order to achieve an acceptable quality of the transmitted video information. These requirements result in a goal conflict. The prior art has no suggestions for solving this conflict.

The results of various simulations show that only the EGPRS using the most protected modulation and coding scheme (MCS-1) available in EGPRS allows an acceptable video quality in typical channel conditions, that is TU3 (Typical Urban Velocity 3 kmph (kilometers per hour); frequency hopping and SNR (Signal to Noise Ratio) > 10 dB. So theoretically MCS1 could be used quite straightforwardly to transmit video information. However, the maximum bit-rate for MCS-1 is 70 kbps (kilo bits per second) when using 8 time slots per TDMA (Time Divisional Multiple Access) frame. A more realistic maximum bit-rate is around 35.2 kbps using 4 time slots. This maximum bit-rate unfortunately is by far not high enough for the majority of video stream sequences (VS). A much higher bandwidth would be necessary to transmit video streaming sequences with an acceptable quality. However, higher data rate MCS cannot guarantee the video quality required for the transmission of video streaming sequences.

For the other MCS with a higher payload, in order to achieve similar error rates as with MCS-1, much higher SNR would be required. Therefore, for the other MCS in typical channel conditions the video bit stream would not be protected enough and the residual error rate in the H.263 file after reception would be too high. As a consequence, a video decoder would not be able to decode the video streaming sequences or, if the decoder succeeded in decoding the video streaming sequences, the resulting video quality would be very poor. The loss of quality is due to VLC-synchronization loss. This can be explained by the fact that 95% of the video bit stream is sensitive to VLC-synchronization loss.

An additional channel coding could be added to protect the video bit stream but the additional bandwidth and complexity required would be too high. Actually, that kind of solution would not be very different from transmitting the whole video bit stream on the MCS-1 coding scheme. The same applies if even more complex protection schemes are used, for example Flexible Layer 1 as proposed in 3GPP (3rd Generation Partnership Project, www.3gpp.org) or GERAN (GSM EDGE RAN, Global System for Mobile Communication Enhanced Data Rates for GSM Evolution Radio Access Network).

Therefore, it is an object of the present invention to find a way of encoding video information so that the resulting video bit stream can be transmitted across a wireless network with a BER (Bit-Error Rate) low enough and at the same time with a transfer rate high enough to achieve an acceptable video quality on the receiving side.

According to the present invention this object is solved by a method for creating a compressed video bit stream from video information of the above-mentioned kind, wherein the code words used for encoding the video information have a fixed length. This would increase its robustness and would limit the problems mentioned above.

According to a preferred embodiment of the present invention it is suggested that the length of the code words to be used for encoding the video information is defined depending on at least one characteristic of the video bit stream.

The proposed solution is to encode the video information by means of code words with a fixed length, whereas the length of the code words can be defined adaptively. With other words, a variable bit-rate video sequence is transmitted using an adaptive fixed length encoding scheme. The fixed length of the code words used for encoding the video information prevents the loss of synchronization and limits error propagation from picture to picture of a video sequence.

According to the present invention, a new encoding method is proposed which is used instead of the conventional image VLC entropy encoding. The length of the code words can be defined based on a characteristic of the video bit stream and/or on properties of the codebook used for encoding. In particular, the length of the fixed code words is defined according to
- the properties of a code word dictionary (codebook) comprising the probability of appearance of the code words,
- an available bit-rate or channel condition on a wireless network used for transmitting the compressed video bit stream or
- a desired quality of the video information after decoding of the compressed video bit stream transmitted across the wireless network.

The Rx/Tx-protocols are synchronized on the length of the fixed-length code words to be used.

A fixed length of the code words of k-bits corresponds to 2^{k} possible code words that can be used for encoding the video information. Now, making reference to Table 1 the variable to fixed length conversion process as part of the present invention is explained in detail.

One example for code words in the sense of the present invention are triplets (run, level, last) mentioned above for the entropy compression according to the H.263 coding standard. In the conventional image VLC entropy encoding, each triplet (run, level, last) is associated with one VLC code word. According to the proposed invention, only the 2^{k} triplets with the highest probability of appearance are selected from the codebook for encoding the video information. In other words, the dictionary comprising the code words used for encoding the video information according to the present invention, is a subset of the entire codebook used for VLC encoding. The dictionary is restricted to code words of a predetermined size k. The other discarded triplets which do not make part of the dictionary and which are not used for encoding the video information according to the present invention, have smaller probabilities of appearance than those which are used for encoding. Nevertheless, if these discarded triplets appear in the image encoding, they are replaced by the nearest triplets among the 2^{k} selected triplets. The decrease in image quality due to this approximation can be made very small due to the fact that the discarded triplets have a very small probability of appearance (see Table 1). Depending on the length of the code words the size of the dictionary will vary. This means that the adaptive size of the dictionary used for encoding the video information according to the present invention is based on the length of the code words and further on the probability of appearance of the code words.

A compression of video information using the method according to the present invention can achieve almost the same image quality than a compression of video information using the EGPRS MCS-1 video encoding standard but at much higher bitrates. The advantages of the present invention are in particular:
- An increased robustness to channel errors thanks to an encoding by means of code words with a fixed length. This means that a target BER can be reduced without any impact on video quality.
- A reduced and controlled bandwidth required for the transmission of video information with a desired quality thanks to an adaptive size of the code word dictionary based on the probability of appearance of the respective code words.

According to an advantageous embodiment of the present invention it is suggested that the length of the code words to be used for encoding the video information is defined depending on at least one of the following characteristics of the video bit stream:
a) bit-rate of the compressed video bit stream;
b) desired quality of the video information after decoding of the compressed video bit stream.

It is further suggested that the codebook comprises a plurality of variable length codes (VLC) used for encoding the video information by means of a conventional VLC-compression mechanism, and that the code words used for encoding the video information are selected from the plurality of said VLCs depending on the probability of appearance of the VLCs during VLC-compression. The code words selected from the codebook and used for encoding the video information according to the present invention are stored in a code word dictionary.

It is suggested that those VLCs, which have a high probability of appearance during VLC-compression, are selected as code words to be used for encoding the video information. Thus, the code word dictionary comprises those code words of the VLC-codebook which have the highest probability of appearance during VLC-compression.

According to a preferred embodiment of the present invention it is suggested that those 2^{k} VLCs which have a high probability of appearance during VLC-compression, are selected as code words to be used for encoding the video information, whereas k is the length of the code words to be selected. The code words have a fixed length k.

According to another preferred embodiment of the present invention it is suggested that a transform compression technology, such as Discrete Cosine Transform (DCT)- or Wavelet-based image coding, is applied to the video information before encoding the video information using code words of a fixed length.

According to yet another preferred embodiment of the present invention it is suggested that the method comprises the following steps:
a) the video information is received from a conventional VLC-encoder in terms of a VLC-encoded signal, the video information comprising Discrete Cosine Transform (DCT)-Coefficients, or wavelet coefficients etc.;
b) the video information received from the VLC-encoder is analyzed in order to determine the probability of appearance of the VLCs during VLC-encoding;
c) the fixed length of the code words to be used for encoding the video information is determined depending on the probability of appearance of the VLCs during VLC-encoding, on the bandwidth available on a wireless network for transmitting the video bit stream after compressing and/or on the condition of a channel used for transmitting the video bit stream; and
d) the VLC-encoded signal is converted to a fixed-length-codes encoded signal.

According to another solution of the object of the present invention a method for transmitting video information across a non-reliable data-link of the above-mentioned kind is suggested, whereas the video bit stream is created from the video information according to one of the claims 1 to 9.

According to a preferred embodiment of the present invention it is suggested that the length of the code words to be used for encoding the video information is defined depending on the bandwidth available on the wireless network for transmitting the video bit stream and/or on the condition of a channel used for transmitting the video bit stream.

According to yet another solution of the object of the present invention an apparatus for creating a compressed video bit stream from video information of the above-mentioned kind is suggested, whereas the apparatus uses only code words for encoding the video information which have a fixed length.

Of course, when realizing the method according to the present invention, apart from the apparatus for creating the compressed video stream on the sending side, a corresponding apparatus on the receiving side is necessary for decompressing the video stream received over the non-reliable data-link. The design of the apparatus on the receiving side can be easily deduced from the features of the apparatus on the sending side and therefore is not mentioned separately at this point.

According to a preferred embodiment of the invention it is suggested that the apparatus further comprises means for performing the method according to any of the claims 2 to 8.

For a more complete understanding of the present invention and the advantages thereof, reference is now made to the following description taken in conjunction with the accompanying drawings, wherein like reference numerals represent like parts, in which:
- Figure 1: illustrates a flowchart of an encoding and a decoding process for video information according to the present invention;
- Figure 2: illustrates an hierarchical organization of a compressed video bit stream compressed according to the H.263 coding standard known from the prior art;
- Figure 3: illustrates a flowchart for an entropy compression according to the H.263 coding standard known from the prior art; and
- Figure 4: illustrates a spatial and temporal error propagation for the H.263 coding standard known from the prior art.

In the example of the H.263 standard known from the prior art, the data payload is encoded using code words with a variable length. These code words are referred to as Variable Length Codes (VLCs). The data payload to be encoded comprises highfrequency Discrete Cosine Transform (DCT) coefficients, referred to as AC coefficients. Figure 4 shows that for the VLCs used in the H.263 standard, a high percentage of data bits are sensitive to synchronization loss. Figure 4 shows an error on one bit of one AC coefficient, which was created in the standard H.263 bit stream at time frame #3. The spatial and temporal error propagation during the following time frames #4 to #9 can be clearly seen. That is why the data payload of video information should be strongly protected against channel errors. Consequently, high data rate payload format cannot be used for transmitting video information because a very low BER < 10⁻⁴ has to be achieved to guarantee a acceptable quality of the compressed video information. After compression, the video information should then be transmitted with MCS-1 or at least MCS-2 when transmitting the information according to the EGPRS-standard. Those are the most protected schemes in EGPRS.

In contrast thereto, the idea of the present invention is to use code words with a fixed length for encoding video information in order to make the resulting video bit stream much more robust to errors than when using code words with a variable length. The length of the code words used for encoding the video information can be adaptively defined. One way of defining the length of the code words is to make use of a VLC-codebook of a VLC-compression mechanism and by selecting the code words to be used for encoding the video information from the plurality of the VLCs depending on the probability of appearance of the VLCs during VLC-compression.

If only those codes are selected from the VLC-codebook which have a very high probability of appearance during VLC-compression, the number of code words used for encoding the video information according to the present invention is relatively small. If additionally codes which have a probability of appearance slightly lower are selected, the number of code words used for encoding the video information according to the present invention is higher. The higher the number of code words used for encoding the video information is, the longer the fixed length k of the code words is. By adaptively defining the fixed length k of the code words used for encoding the video information according to the present invention the size of the dictionary comprising the code words used for encoding the video information is adapted, too. By adaptively defining the size of the dictionary, the bit-rate required for transmitting the video information with a video quality similar to the quality of EGPRS MCS-1 transmission can be significantly reduced.

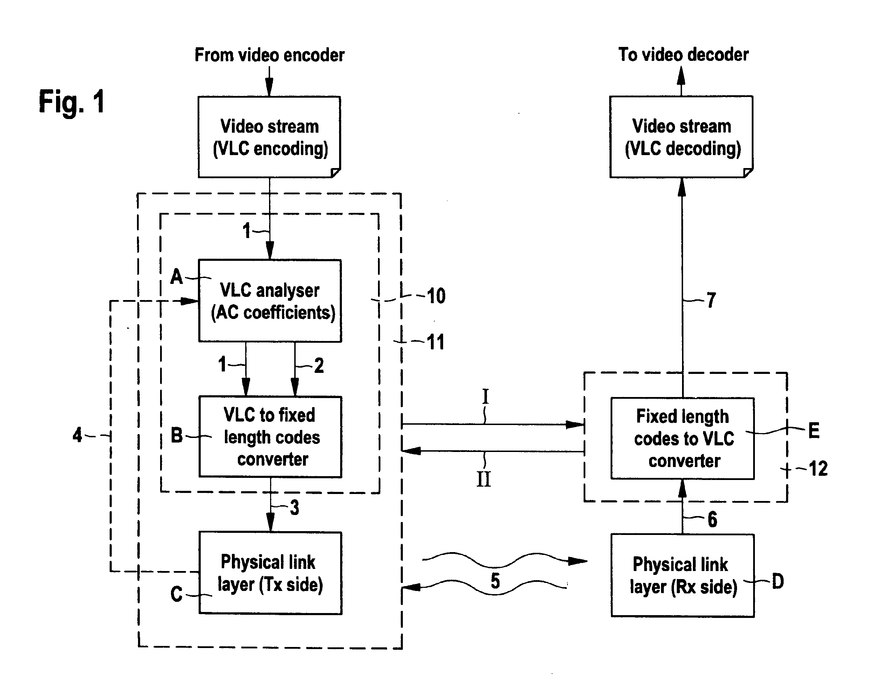

Referring now to figure 1, an apparatus for creating a compressed video bit stream from video information according to the present invention as a whole is designated with reference sign 10. The apparatus 10 can be installed on the transmission side of a transmission media 5, for example a wireless network. The apparatus 10 defines the required length k of the code words used for encoding the video information based on the properties of the VLC-codebook comprising VLCs, and eventually on the actual bit-rate available for transmission of the compressed video bit stream, on the channel condition, on the desired video quality of the video information decoded from the compressed video bit stream received etc. So the number of the selected code words (triplets) is between 2^{k-1} + 1 and 2^{k}. That part of the invention can be done by a video stream analyzer A and a video encoder B for converting variable length codes (VLC) to fixed length code words.

The video stream analyzer A constructs the codebook statistics. It has the complete VLC codebook with all the variable length codes used for VLC conversion and their probabilities of appearance. The video stream analyzer A receives the video stream according to a RTP (Real-time Transmission Protocol)/UDP (User Datagram Protocol)/IP (Internet Protocol) frames and video information in a VLC-format (see reference sign 1). Furthermore, the video stream analyzer A receives an indication of the available bandwidth and/or of the channel quality (see reference sign 4). Further, the video stream analyzer A creates the code word dictionary comprising the code words used for encoding the video information according to the present invention.

The video encoder B receives the video stream RTP/UDP/IP and the video information 1 in the VLC-format, too. The input information of the video encoder B comprises protocol messages with the length k for the fixed length encoding (see reference sign II) and an indication of the resolution to encode VLC (see reference sign 2). By means of the information provided to the video encoder B it converts the VLC to the fixed length code words and a new encoding of the video information is performed.

Then, the video stream RTP/UDP/IP and the video bit stream in the fixed length code word format of the size k is transmitted to a physical link layer C on the transmitting side (Tx) of the transmission media 5, for example a wireless network. The physical link layer C includes a RLC (Radio Link Control)/MAC (Medium Access Control)/physical layer. Reference sign 11 designates an apparatus for transmitting the compressed video information across the wireless network 5, comprising the apparatus 10 for creating a compressed video bit stream 3 and the transmitter C on the physical link layer on the transmitting side (Tx).

At the receiving side (Rx), the inverse operation is performed by the video decoder E for converting the fixed length code words to Variable Length Codes (VLC). The video decoder E reconstructs the original VLC encoded video information 7 from the video bit stream 6 in the fixed length code word format of the length k. The original VLC-encoded video sequence 7 is then conventionally processed by a standard VLC video decoder. Of course, in order to perform this operation, the receiver (Rx) needs to know the value of the length k used by the video encoder B on the transmitter (Tx)-side. For that purpose the signaling messages I, II are required between the video converters B and D. The same messages I, II can be used to initialize the process and/or to modify it during the transmission of the video sequence, for example after the transmitter (Tx) has changed the value of the length k of the code words used for encoding the video information 1 according to the present invention.

Determining the length k of the code word used for encoding the video information 1 according to the present invention, is described below by means of an example for the H.263-standard. The complete codebook used for VLC-encoding according to the H.263-standard comprising the VLCs with a variable length and the probabilities of appearance for four typical video sequences VS1, VS2, VS3 and VS4 are listed in table 1. It can be seen that only 18 code words (triplets) over 102 code words have a probability of appearance higher than 1%. The probability of appearance depends on the video sequence property, like texture, change of scene etc. This implies that an adaptive mechanism is required to determine the length k of the code word used for encoding the video information 1 according to the present invention.

The adaptive mechanism on the transmission side (Tx) determines the length k based on the properties of the codebook and also on the available bandwidth (or bit-rate) and on the channel condition of the transmission media 5, for example a wireless network, used for transmitting the compressed video bit stream 3 to a mobile communication terminal, e. g. a mobile phone. If the available bit-rate is high, a high resolution, i. e. larger values for the length k, can be used. For instance, in the embodiment mentioned above according to the H.263-standard all the 102 triplets (run, level, last) of the codebook are used and coded on a fixed length of 7 bits. If the available bit-rate is less, only 6 bits of fixed length k are used, so only 64 (=2⁶) triplets (run, level, last) are used for encoding the video information 1 according to the present invention. Nevertheless, even if the resolution is less, a very good image quality can be obtained, because the triplets (run, level, last), which are ignored have small probabilities of appearance and, therefore, their absence barely affects the image quality. Further, a third resolution level can be used with a length k of only 5 bits and consequently only 32 (=2⁵) triplets (run, level, last).

Simulation results have shown that the best image quality can be achieved by using code words with a fixed length k, the length k corresponding to the maximum length of the VLC-codes of the VLC-codebook. However, only the code words with the fixed length of k are used for encoding the video information 1 according to the present invention. An important point of the present invention is how the VLC-codes of the VLC-codebook are converted to code words with a fixed length k for the code word dictionary with no or only little degradation in video quality. Therefore, only the 2^{k} codes from the VLC-codebook with the highest occurrence probabilities are selected for the smaller fixed length code word dictionary. The other VLC-codes with a lower occurrence are replaced by the (in the image and video sense) nearest selected VLC-codes with a length of k bits.

According to the present invention, all the other VLC-codes with a length of k-1, k-2, ... 1 contained in the VLC-codebook are used for encoding the video information, too, but with a fixed length k. The conversion of the VLC-codes with a length of k-1, k-2, ..., 1 into codes with a fixed length of k can be achieved in many different ways.

Simulation results have further shown, that when using code words of a fixed length of k-1, k-2 or even less bits, for the example mentioned above by using code words with a fixed length of k=6 bits or k=5 bits, the deterioration of image quality is very small and can hardly be recognized by a perceived observer looking at the decoded video information. It has to be noted that with the example mentioned above, even when using code words of a length of k=5 bits, the image quality achieved is far better than the image quality of decoded video information which can be achieved with conventionally VLC-encoding the video information by using codes with a variable length, transmitting the resulting video bit stream across the wireless network 5 to the mobile communication terminal, and VLC-decoding it there.

Encoding a transmission with code words of the length k of only 6 bits or 5 bits with less code words is equivalent to selecting the 64 or 32 triplets (run, level, last) with the highest probabilities of appearance. In the video bit stream 3, if a triplet (run, level, last) is used and it is not among the 64 or 32 selected triplets (run, level, last), then it will be replaced by the closest triplet (run, level, last) among the selected ones. The closest triplet (run, level, last) is related to the image meaning. For example, for a given application, a criteria C is used to a evaluate the image or video quality. The closest triplet would be that triplet that would optimize the criteria C. A criteria often used is the PSNR (Peak-to-peak Signal to Noise Ratio) for image and video. A way to replace a triplet with the closest triplet is to replace the triplet (run, level, last) with another triplet having the same "last"-value, the nearest "level"-value and the nearest "run" value.

Concerning the implementation of the present invention on the sending side (Tx side), the operation of converting VLC-encoded data into data encoded with fixed length codes can be performed at:
- a source encoder, which requires modification of the video encoder standards, at least in order to add an additional option,
- the RTP (Real-Time Transmission Protocol)-level when building the video information into RTP/UDP/IP-frames,
- the SNDCP (Sub Network Dependent Convergence Protocol)/PDCP (Packet Data Convergence Protocol)-layers for cellular systems, e. g. in a NSS (Network Sub System) equipment,
- the RLC (Radio Link Control)/MAC (Medium Access Control)-level, e. g. in a RAN (Radio Access Network) equipment,
- a dedicated video compression function between RTP and the physical layer of the wireless network link, e. g. in a RTP/UDP/IP header compression function.

Concerning the implementation of the present invention on the receiving side (Rx), the operation of converting data encoded with fixed length codes into VLC-encoded data can be performed at:
- a source decoder, which requires modification of the video decoder standards, at least in order to add an additional option,
- the RTP (Real-Time Transmission Protocol)-level when converting the RTP/UDP/IP-frames into the video information,
- the SNDCP (Sub Network Dependent Convergence Protocol)/PDCP (Packet Data Convergence Protocol)-layers for cellular systems, e. g. in a NSS (Network Sub System) equipment,
- the RLC (Radio Link Control)/MAC (Medium Access Control)-level, e. g. in a RAN (Radio Access Network) equipment,
- a dedicated video decompression function between RTP and the physical layer of the wireless network link, e. g. in a RTP/UDP/IP header decompression function.

The present invention avoids propagation errors due to synchronization loss in the payload of video information. If an error occurs on one bit of a conventional H.263-data stream, the remaining video bit stream is corrupted until the decoder realizes that an error has occurred or until the next synchronization code is found. Usually, the errors propagate temporarily for a while and a big part of the video information is lost, until the next INTRA-coded blocks are received. INTRA-coded frames and blocks are coded with no reference to other frames or blocks and therefore can be reconstructed without any reference to other frames or blocks. The image quality of the resulting video sequence is very poor.

In the proposed H.263-bit stream according to the present invention, the error is local. Only the code word that the corrupted bit belongs to is damaged and the remaining bit stream is undamaged. Because one erroneous AC-coefficient is not very significant, the residual error usually is not visible in the decoded video information.

With the compression of video information according to the present invention a H.263-video bit stream can be transmitted using less protected transmission schemes having a higher data rate. E. g. with EGPRS, MCS-3 to MCS-9 can be used instead of MCS-1 or MCS-2, which have to be used for transmitting a video bit stream which was conventionally VLC-encoded.

Furthermore, the video quality of the decoded video information is controlled and the length k of the code words used for encoding the video information according to the present invention is adaptively adjusted. The video quality can be controlled, since the number of bits of the code words used for encoding conventional VLCs into fixed size code words is based on the probability of appearance of the codes. This adaptive system reduces the bit-rate required for the transmission without a significant reduction in image quality.

The method for compression of video information according to the present invention can be applied to any conventional compression mechanism that makes use of VLC-encoding for the data blocks or the payload, e. g. MPEG4 (Motion Joint Picture Expert Group) or JPEG (Joint Picture Expert Group).

In typical video sequences VS1, VS2, VS3 and VS4, and in the H.263-standard, AC coefficients represent about 80% of the video bit stream. They are sensitive to synchronization loss. According to the present invention, all these information bits are no longer sensitive to synchronization loss. Simulation results show that significant gain can be obtained in terms of PSNR (Peak-To-Peak Signal to Noise Ratio).

**Table 2:**

| Comparison between conventional VLC-encoding and fixed length code word-encoding according to the present invention | | | |
|---|---|---|---|
| **Video streaming sequences** | **VLC coding (PSNR in dB)** | **Fixed codeword (PSNR in dB)** | **Gain (PSNR in dB)** |
| VS1: error #1 | 9,2 | 51,6 | 42,4 |
| VS1: error #2 | 18,2 | 34,8 | 16,6 |

To get the simulation results shown in table 2, an error on one bit of the AC-coefficients payload was created in the conventional H.263 video bit stream known from the prior art and in the proposed H.263 video bit stream encoded according to the present invention. It can be seen that for the same video sequence VS1, the error is on the same coefficient, i. e. the same position and the same code word.

## Claims

1. A method for creating a compressed video bit stream (3) from video information (1) for transmission over a non-reliable data-link comprising the steps of:
a. receiving the video information (1) to be compressed;
b. receiving code words from a codebook comprising a plurality of codes for encoding the video information (1); and
c. encoding the video information (1) and creating the video bit stream (3) using said code words received from the codebook,
**characterized in that** the code words used for encoding the video information (1) have a fixed length (k).

2. The method according to claim 1, **characterized in that** the length (k) of the code words to be used for encoding the video information (1) is defined depending on at least one characteristic of the video bit stream (3).

3. The method according to claim 2, **characterized in that** the length (k) of the code words to be used for encoding the video information is defined depending on at least one of the following characteristics of the video bit stream (3):
a. bit-rate of the compressed video bit stream (3);
b. desired quality of the video information (7) after decoding of the compressed video bit stream (6).

4. The method according to claim 1, **characterized in that** the codebook comprises a plurality of variable length codes (VLC) used for encoding the video information (1) by means of a VLC-compression mechanism, and that the code words used for encoding the video information (1) are selected from the plurality of said variable length codes (VLC) depending on the probability of appearance of the variable length codes (VLC) during VLC-compression.

5. The method according to claim 4, **characterized in that** those variable length codes (VLC), which have a high probability of appearance during VLC-compression, are selected as code words to be used for encoding the video information (1).

6. The method according to claim 4 or 5, **characterized in that** those 2^{k} variable length codes (VLC), which have a high probability of appearance during VLC-compression, are selected as code words to be used for encoding the video information, whereas k is the length of the code words to be selected.

7. The method according to one of the preceding claims, **characterized in that** a transform compression technology, such as Discrete Cosine Transform (DCT)- or Wavelet-based image coding, is applied to the video information before encoding the video information using the code words of a fixed length.

8. The method according to claim 7, **characterized by** the following steps:
a. the video information (1) is received from a VLC-encoder in terms of a VLC-encoded signal, the video information (1) comprising discrete cosine transform coefficients;
b. the video information (1) received from the VLC-encoder is analyzed in order to determine the probability of appearance of the variable length codes (VLC) during VLC-encoding (A);
c. the fixed length (k) of the code words to be used for encoding the video information (1) is determined depending on the probability of appearance of the variable length codes (VLC) during VLC-encoding, on the bandwidth (4) available on a transmission media (5) for transmitting the video bit stream (3) after compression and/or on the condition of a channel used for transmitting the video bit stream (3); and
d. the VLC-encoded signal (1) is converted to the video bit stream (3) in terms of a fixed-length-codes-encoded signal.

9. The method according to claim 8, **characterized in that** the transmission media (5) is a wireless network.

10. A Method for transmitting video information (1) across a transmission media (5), wherein the video information (1) is compressed into a video bit stream (3) and the video bit stream (3) is transmitted across the transmission media (5), **characterized in that** the video bit stream (3) is created from the video information (1) according to one of the preceding claims.

11. The method according to claim 10, **characterized in that** the length of the code words to be used for encoding the video information (1) is defined depending on the bandwidth available on the transmission media (5) for transmitting the video bit stream (3) and/or on the condition of a channel used for transmitting the video bit stream (3).

12. A method for creating decompressed video information (1) from a video bit stream (3) transmitted over a non-reliable data-link comprising the steps of:
a. receiving the video bit stream (3) to be decompressed;
b. receiving code words from a codebook comprising a plurality of codes for encoding the video information (1); and
c. decoding the video bit stream (3) and creating the video information (1)using said code words received from the codebook,
**characterized in that** the code words used for decoding the video bit stream (3) have a fixed length (k).

13. A method for receiving video information (1) across a transmission media (5), wherein a video bit stream (3) comprising compressed video information (1) is transmitted across the transmission media (5) and the video bit stream (3) is decompressed in order to create the video information (1), **characterized in that** the video information (1) is created from the video bit stream (3) according to claim 12.

14. An apparatus (10) for creating a compressed video bit stream (3) from video information (1) comprising:
a. means (A) for receiving the video information (1) to be compressed;
b. means (B) for receiving code words from a codebook comprising a plurality of codes for encoding the video information; and
c. means (B) for encoding the video information (1) and creating the video bit stream (3) using said code words received from the codebook,
**characterized in that** the apparatus (10) uses only code words for encoding the video information (1) which have a fixed length (k).

15. The apparatus (10) according to claim 11, **characterized in that** the apparatus (10) further comprises means for performing the method according to any of the claims 2 to 9.

16. An apparatus (12) for creating decompressed video information (1) from a video bit stream (3) comprising:
a. means (D) for receiving the video bit stream (3) to be decompressed;
b. means (E) for receiving code words from a codebook comprising a plurality of codes for encoding the video information; and
c. means (E) for encoding the video bit stream (3) and creating the video information (1) using said code words received from the codebook,
**characterized in that** the apparatus (12) uses only code words for decoding the video bit stream (3) which have a fixed length (k).
